# EUROPÄISCHE PATENTSCHRIFT

(11) **EP 0 880 607 B1**
(45) Veröffentlichungstag und Bekanntmachung des Hinweises auf die Patenterteilung: **13.06.2001**
(21) Anmeldenummer: 97913008.5
(22) Anmeldetag: 19.11.1997
(51) Int. Cl.: C23C 28/00, C23C 28/02, C23C 4/02, C23C 14/02, C23C 16/02

(54) **OXIDATIONSSCHUTZSCHICHT FÜR REFRAKTÄRMETALLE**
OXIDATION PROTECTIVE COATING FOR REFRACTORY METALS
COUCHE DE PROTECTION CONTRE L'OXYDATION POUR METAUX REFRACTAIRES

(30) Priorität: 22.11.1996 AT 68796
(43) Veröffentlichungstag der Anmeldung: 02.12.1998
(73) Patentinhaber: PLANSEE Aktiengesellschaft, 6600 Reutte, Tirol (AT)
(72) Erfinder: BARBIST, Roland, A-6600 Wängle (AT); KNABL, Wolfram, A-6600 Reutte (AT); MARTINZ, Hans-Peter, A-6600 Höfen (AT); RÖDHAMMER, Peter, A-6600 Reutte (AT)
(74) Vertreter: Lohnert, Wolfgang, Dr.
(86) Internationale Anmeldenummer: AT9700251
(87) Internationale Veröffentlichungsnummer: WO9823790

(56) Entgegenhaltungen:
- EP-A- 0 199 307
- EP-A- 0 223 104
- GB-A- 1 043 579
- US-A- 2 683 305
- CHEMICAL ABSTRACTS, vol. 92, no. 24, 16.Juni 1980 Columbus, Ohio, US; abstract no. 202120, PROKOSHKIN, D. A. ET AL: "Plasma coatings made from molybdenum disilicide for niobium and its alloys" XP002061534 & ZASHCH. POKRYTIYA, TR. VSES. SOVESHCH. ZHAROSTOIKIM POKRYTIYAM, 8TH (1979), MEETING DATE 1977, 108-11. EDITOR(S): BORISENKO, A. I. PUBLISHER: IZD. NAUKA, LENINGRAD. OTD., LENINGRAD, USSR. CODEN: 42XWAB, 1979,
- E.M. PASSMORE,J.E. BOYD,B.S.LEMENT: "selection of diffusion barriers for use in protective coating systems for tungsten and molybdenum" METALLUGICAL SOCIETY CONFERENCES, Bd. 30, 1966, LONDON,GB, Seiten 681-692, XP002061533
- DATABASE WPI Section Ch, Week 8008 Derwent Publications Ltd., London, GB; Class M13, AN 80-14023C XP002061535 & JP 55 006 426 A (SUWA SEIKOSHA KK) , 17.Januar 1980

## Beschreibung

Die Erfindung betrifft einen Grundkörper, aus einem hochschmelzenden Metall aus der Gruppe Chrom, Molybdän, Wolfram, Tantal, Niob und deren Legierungen bzw. Verbundwerkstoffen und einer Oxidationsschutzschicht aus Siliziden oder Aluminiden.

Hochschmelzende Metalle besitzen die Eigenschaften bis zu höchsten Temperaturen ihre Festigkeit beizubehalten. Problematisch ist jedoch, daß diese Metalle und Legierungen eine nur geringe Widerstandsfähigkeit gegenüber Oxidation aufweisen, wenn sie bei hohen Temperaturen von über 400°C Luft oder anderen oxidierenden Medien ausgesetzt sind.

Um diese starke Oxidationsanfälligkeit zu verbessern, ist es bekannt, die Oberfläche der hochschmelzenden Metalle mit entsprechenden Schutzschichten zu versehen. Für viele Anwendungen hat sich die Aufbringung von Beschichtungen aus Siliziden oder Aluminiden bewährt.
In der US 3 540 863 werden beispielsweise CrFe-Silizidschichten als Oxidationsschutzschicht für einen Grundwerkstoff aus Niob oder Niobbasislegierungen beschrieben.
Derartige Beschichtungen werden nach der Aufbringung durch eine Diffusionsglühbehandlung aufgeschmolzen. Dieses Überschmelzen ist bei diesen Silizid- bzw. Aluminidschichten, die heute fast ausschließlich durch Schlickerbeschichtung bzw. Plasmaspritzen aufgebracht werden, zwingende Voraussetzung zur Homogenisierung der Schichtkomponenten sowie zur Herstellung der erforderlichen Sperre der Schicht gegenüber Sauerstoffpermeation.
Durch diese Diffusionsglühbehandlung wird die Schichtzusammensetzung durch Anlösung des Grundwerkstoffes und Einbau der Grundwerkstoffkomponenten in die Beschichtung modifiziert und es bilden sich mehrphasige und mehrlagige Oxidationsschutzschichten, die an der Grenzfläche zum nicht angelösten Grundmaterial eine oder mehrere Lagen von intermetallischen Phasen aufweisen, die sich nach geltender Lehrmeinung als Haftvermittler vorteilhaft auf die Schichthaftung der Oxidationsschutzschicht auswirken.

Nachteilig dabei ist einerseits, daß die Anlösung der Komponenten des Grundwerkstoffes zwingend erfolgt, ob die Komponenten nun einen positiven oder negativen Einfluß auf die Funktion der Oxidationsschutzschicht haben, andererseits, daß Diffusionsprozesse, die Anteile des Grundmaterials in die Oxidationsschutzschicht überführen, auch noch während des bestimmungsgemäßen Hochtemperatureinsatzes des beschichteten Grundkörpers weiter ablaufen. In der Oxidationsschicht sind diese Prozesse jedoch in jedem Fall unerwünscht, da sie das chemische und physikalische Verhalten derselben verändern und ihre Lebensdauer sowie ihren Verbund mit dem Grundwerkstoff kontinuierlich verschlechtern.

Die EP-A2 0 304 176 beschreibt einen mit einer Oxidationsschutzschicht versehenen Gegenstand aus einem hochschmelzenden Metall, der mit einer aufgeschmolzenen Silizidschicht beispielsweise der Zusammensetzung 20 % Cr, 20 % Fe, Rest Si versehen ist. Um im Einsatz des beschichteten Gegenstandes die thermische Belastbarkeit zu erhöhen, wird die Oxidationsschutzschicht mit einer äußeren Keramikschicht versehen, welche die Funktion einer thermischen Barriere erfüllt.

Doch eine derartige Maßnahme hat keine Wirkung dahingehend, die unkontrollierten Lösungsvorgänge zwischen Grundmaterial und Oxidationsschutzschicht während des Einsatzes zu verhindem.

Vereinzelt sind auch Gegenstände mit Oxidationsschutzschichten bekannt geworden, die zwischen Grundmaterial und Oxidationsschutzschicht eine Reaktionssperrschicht aufweisen. Derartige Schichtaufbauten haben sich in der Praxis jedoch nur in sehr speziellen Anwendungsgebieten (z.B. in der Glasindustrie) und dort wiederum nur für ganz spezielle Anwendungen und in Verbindung mit einer Oxidationsschutzschicht aus einem Metall bzw. einer Legierung der Platingruppe durchgesetzt; wie beispielsweise in der GB 1 195 349 beschrieben.

Die EP 0 223 104 A1 nennt eine Beschichtung für ein Substrat und ein Verfahren zu dessen Herstellung. Das Substrat ist vorteilhafterweise ein Refaktärmetall. Die dort als wesentlich ausgewiesene Beschichtung aus Aluminiumsilikat hat die Aufgabe, das Substrat mittels einer fest haftenden Schicht dicht, d.h. porenfrei, gegenüber der Umgebung abzudecken. Nach einer bevorzugten Ausführung wird die Aluminiumsilikatschicht auf der Außenseite mit einer Schicht aus MoSi₂ bzw. MoSi₂-Matrix Aluminiumsilikat umgeben. Eine Mo-Silikatschicht weist jedoch den Nachteil auf, dass sie bei Temperaturen zwischen ca. 700 und 900°C in oxidierender Atmosphäre in MoO₃ und SiO₂ umwandelt und dabei mechanisch zerfällt.

Die Aufgabe der vorliegenden Erfindung ist es daher, einen Gegenstand aus einem Grundkörper aus einem hochschmelzenden Metall und einer Oxidationsschutzschicht aus Siliziden oder Aluminiden zu schaffen, wobei die Schicht hinsichtlich des Einsatzes unabhängig von der Zusammensetzung des Grundmaterials optimiert ist. Gleichzeitig sind in einem solchen Gegenstand unkontrollierte Lösungsvorgänge des Grundmaterials in der Oxidationsschutzschicht bzw. umgekehrt, während der Herstellung des beschichteten Bauteils und während des Einsatzes auszuschalten.

Erfindungsgemäß wird dies gemäß Anspruch 1 dadurch erreicht, daß zwischen Grundkörper und Oxidationsschutzschicht eine Reaktionssperrschicht angeordnet ist und, daß die Oxidationsschutzschicht mit einem oder mehreren Metallen aus der Gruppe Molybdän, Niob, Tantal und Hafnium in einem Gesamtanteil von 2 bis 35 at.% legiert ist.

Die Erfindung geht also einen völlig neuen Weg, indem sie den zwingenden Einbau von hochschmelzenden Metallen aus dem Grundmaterial in einer aus der Verfahrenstechnik und aus dem Einsatz vorgegebenen, je nach Temperatur wechselnden Konzentration durch die Anordnung einer Reaktionssperrschicht verhindert, dafür aber gezielt hochschmelzende Metalle in der jeweils optimierten Konzentration gezielt in die Oxidationsschutzschicht miteinbaut, um damit nach wie vor die Vorteile dieser Metalle in der Oxidationsschicht zu erhalten und gleichzeitig eine unkontrollierbare Lösung und Diffusion dieser Metalle aus dem Grundwerkstoff während der Herstellung und während des Einsatzes mit Sicherheit zu verhindern.

Auf diese Weise kann einerseits eine vom Grundmaterial und dem Herstellprozeß unabhängige Zusammensetzung der Oxidationsschutzschicht erreicht werden sowie andererseits eine fortwährende, zyklische Veränderung der Zusammensetzung der Oxidationsschutzschicht während wechselnder Tempertaurbelastungen sowie über sehr lange Zeiträume bei gleichbleibenden Temperaturen verhindert werden.

Insbesondere wird auch eine während des Einsatzes unkontrolliert fortschreitende Ausbildung spröder intermetallischer Phasen an der Übergangszone Grundmaterial/ Oxidationsschutzschicht, die eine Verminderung der Dicke der effektiven Oxidationsschutzschicht bewirken, unterbunden. Auch eine kritische Versprödung des Verbundes Grundwerkstoff/Oxidationsschutzschicht, die häufig Ursache für verringerte Standzeiten ist, wird dadurch langfristig unterbunden.

Durch das Verhindern der Reaktion von Schichtkomponenten mit dem Grundmaterial und Abdiffusion von Schichtkomponenten in das Grundmaterial lassen sich bei vergleichsweise dünneren Schutzschichten erheblich längere Standzeiten mit gleichbleibenden Eigenschaften des Schichtsystems in der Verbundzone erreichen.

Unter Siliziden sind Legierungen auf Siliziumbasis mit mindestens 60 at% Si und 5 - 40 at% von einem oder mehreren Elementen aus der Gruppe Cr, Fe, Ti, Zr, Hf, B und C und unter Aluminiden Legierungen auf Aluminiumbasis mit mindestens 60 at% Al und 5 - 40 at% von einem oder mehreren Elementen aus der Gruppe Si, Cr, Ti, Zr, Hf, Pt, B und C zu verstehen.

Die Auswahl des bzw. der Metalle, mit dem erfindungsgemäß die Oxidationsschutzschicht legiert ist, richtet sich nicht nur nach der Minimierung der Zunderkonstante, sondern auch nach den Einsatzbedingungen im Hinblick auf stationäre oder zyklische Temperaturbelastung. Auch die thermischen Ausdehnungskoeffizienten des jeweils vorliegenden Grundkörpers sind bei der Auswahl zu berücksichtigen.
In der Regel wird eine optimale Anpassung der thermischen Ausdehnungskoeffizienten von Grundmaterial, Reaktionssperrschicht und Oxidationsschutzschicht die Temperaturwechselbeständigkeit des jeweiligen Verbundgegenstandes wesentlich erhöhen.

Je nach Anwendungsfall kann ein Zulegieren desselben Metalles, aus dem im wesentlichen der Grundkörper besteht; (z.B. mit Niob legierte SiCrFe-Oxidationsschicht bei einem Grundkörper aus Niob oder einer Niob-Basislegierung) oder aber das Zulegieren eines anderen Metalles (z.B. mit Molybdän legierte SiCrFe-Schicht bei einem Grundkörper aus Niob oder einer Niob-Basislegierung) die besten Standzeitergebnisse im Einsatz erbringen.

Der wesentliche Vorteil der durch die Erfindung erreicht wird ist, daß der Anwender nicht mehr ausschließlich auf die sich automatisch ergebende Legierungsbildung der Oxidationsschutzschicht mit ganz bestimmten Anteilen des Grundmaterials entsprechend dem Stand der Technik eingeschränkt ist und die Möglichkeit besteht, die Oxidationsschutzschicht mit frei wählbaren Legierungsanteilen unter Berücksichtigung der jeweiligen speziellen Einsatzbedingungen zu optimieren.

Als Reaktionssperrschichten sind insbesondere oxidische Schichten wie Y₂O₃, HfO₂, ZrO₂, La₂O₃, TiO₂, Al₂O_{3,} aber auch karbidische oder nitridische Schichten wie HfC, TaC, NbC oder Mo₂C bzw. TiN, HfN oder ZrN geeignet. Die Auswahl des Schichtsystems, der Schichtstärke sowie des Beschichtungsverfahrens richtet sich hiebei nach Werkstoff und Abmessungen der zu schützenden Komponente einerseits und den Einsatzbedingungen andererseits.

Grundvoraussetzung für die erfolgreiche Anwendung der erfindungsgemäßen Idee ist es, daß die thermische Zyklierbarkeit, die nach dem Stand der Technik für die gegenständlichen Oxidationsschutzschichtsysteme ausgezeichnet ist, durch die Reaktionssperrschicht nicht einsatzrelevant herabgesetzt wird. Daher ist auf eine optimierte Anpassung der thermischen Ausdehnungskoeffizienten von Grundmaterial und Sperrschicht zu achten. Auch kann sich das Vorhandensein einer Restporosität, wie sie z.B. in thermisch gespritzen Schichten in der Regel vorliegt, und die dadurch bewirkte Pseudoplastizität vorteilhaft auf das Verbundverhalten auswirken. Die Schichtstärken der Reaktionssperrschichten werden in der Regel 5 µm - 20 µm für volldichte Schichten bzw. 20 µm - 100 µm für Schichten mit Restporosität betragen.

Grundsätzlich kommen sämtliche bekannte Beschichtungsverfahren für die Abscheidung der Reaktionssperrschicht in Betracht, wie z.B. Chemische Dampfabscheidung, Physikalische Dampfabscheidung oder Plasmaspritzen von Pulver. Besonders bewährt hinsichtlich thermischer Zyklierbarkeit hat sich das Atmosphärische Plasmaspritzen z.B. von HfO₂ oder ZrO₂. Die Reaktionssperrschicht kann aber auch durch eine Reaktion von vorab deponierten Komponenten (z.B. Kohlenstoff) mit dem Grundwerkstoff (z.B. zu Karbiden) oder durch Umsetzung mit einer reaktiven Gasphase (z.B: CHₓ, N₂) zu einem Karbid oder Nitrid des Grundwerkstoffes ausgebildet werden. Die Oxidationsschutzschicht selbst kann ebenfalls mit allen hiefür sonst üblichen Beschichtungsverfahren abgeschieden werden, mit Ausnahme des Packzementierens. Verfahrenstechnische Vorteile bietet das Thermische Spritzen von Reaktionssperrschicht und Oxidationsschutzschicht in unmittelbar aufeinanderfolgenden Arbeitsgängen.

Besonders bewährt hat es sich, wenn die Oxidationsschutzschicht mit einem oder mehreren Metallen aus der Gruppe Molybdän, Niob, Tantal und Hafnium in einem Gesamtanteil von 15 - 25 At% legiert ist.

Wenn der Grundkörper aus Tantal oder Niob bzw. deren Legierungen oder Verbundwerkstoffen besteht, haben sich insbesondere Oxidationsschutzschichten aus Siliziden oder Aluminiden bewährt, die mit 15 - 25 At% Molybdän legiert sind.

Für die Reaktionssperrschichten haben sich insbesondere Oxidschichten und dabei in ganz besonderer Weise Zirkonoxid- oder Hafniumoxidschichten als besonders vorteilhaft herausgestellt. Als besonders bevorzugtes Verfahren zur Aufbringung dieser Reaktionssperrschichten hat sich das atmosphärische Plasmaspritzen bewährt.

Die genannte Reaktionssperrschicht weist vorteilhafterweise eine Schichtstärke zwischen 40 und 60 µm auf. Schichten dieser Stärke erfüllen ihre Sperrwirkung gegenüber Materialdiffusion ausreichend vollständig und lassen sich doch noch innerhalb wirtschaftlicher Herstellzeiten auf dem Substrat abscheiden.

Im folgenden wird die Erfindung anhand eines Herstellungsbeispieles näher erläutert:

### BEISPIEL

Ein stabförmiger Probekörper aus der Nb-Basislegierung Nb10W2,5Zr wurde mittels Atmosphärischem Plasmaspritzen mit einer ca. 50 um dicken Reaktionssperrschicht aus HfO₂ allseitig beschichtet. In einem anschließenden Arbeitsgang wurde ebenfalls mittels Atmosphärischem Plasmaspritzen auf diese Reaktionssperrschicht eine modifizierte Silizidschicht (Si15Cr15Fe20Mo) abgeschieden. Die so erhaltene Silizidschicht wurde anschließend bei 1250°C im Vakuum überschmolzen (Haltezeit: 15 min.) Als Referenz wurde in analoger Weise eine Probe ohne Reaktionssperrschicht hergestellt. Im anschließenden Oxidationstest (1300°C, 30 min. Haltezeit; 40 Zyklen zwischen 200°C und Haltetemperatur) zeigte die Probe mit molybdänlegierter Silizidschicht und Reaktionssperrschicht eine spezifische Gewichtszunahme von 1,4 mg/cm². Der gemessene Referenzwert der Probe ohne Reaktionssperrschicht betrug 3,2 mg/cm². Eine zwecks Differentialdiagnose angefertigte Probe mit 10 % Mo im Schichtmaterial, jedoch ohne Reaktionssperrschicht, zeigte anfänglich ein gegenüber dem Standard ebenfalls verbessertes Oxidationsverhalten, näherte sich jedoch ab dem 15. Zyklus rasch an die Gewichtszunahmekurve der Standardprobe an.

In einem weiteren Oxidationstest wurde das Langzeitverhalten unter gleichbleibender Temperaturbelastung an Luft überprüft. Nach 500 h Auslagerung bei 1300°C durchgeführte metallographische Analysen zeigen, daß im Fall der erfindungsgemäßen Schutzschicht die sich im Test ausbildende, passivierende oxidische Deckschicht wesentlich gleichmäßiger ausbildet als im Falle der Probe ohne Reaktionssperrschicht, mit einer wesentlich geringeren Oberflächenrauhigkeit.
Nach 500 h Testdauer stehen von ursprünglich 100 µm Silizidschichtdicke noch 55 µm als Opfermaterial zum weiteren Wachstum der passivierenden Oxidschicht zur Verfügung. Im Falle der Probe ohne Reaktionssperrschicht ist unter gleichen Bedingungen als Folge der unregelmäßigeren Passivierungsschicht einerseits und der Abreaktion von Silizium, in geringem Umfang auch Cr und Fe, zu Nb-Basis-Siliziden die Reststärke der Opferschicht bereits auf 25 µm abgefallen. Für die Prognose der Lebensdauer der jeweiligen Komponenten bedeutet dieses Ergebnis einen Standzeitvorteil der erfindungsgemäß beschichteten Probe von mehr als 100 %.

## Patentansprüche

1. Gegenstand aus einem Grundkörper, aus einem hochschmelzenden Metall aus der Gruppe Chrom, Molybdän, Wolfram, Tantal, Niob und deren Legierungen bzw. Verbundwerkstoffen und einer Oxidationsschutzschicht aus Siliziden mit mindestens 60 At% Si und 5 - 40 At% von einem oder mehreren Elementen aus der Gruppe Cr, Fe, Ti, Zr, Hf, B und C oder Aluminiden mit mindestens 60 At% Al und 5 - 40 At% von einem oder mehreren Elementen aus der Gruppe Si, Cr, Ti, Zr, Hf, Pt, B und C,
**dadurch gekennzeichnet,**
dass zwischen Grundkörper und Oxidationsschutzschicht eine Reaktionssperrschicht angeordnet ist und dass die Oxidationsschutzschicht mit einem oder mehreren Metallen aus der Gruppe Molybdän, Niob, Tantal und Hafnium in einem Gesamtanteil von 2 bis 35 At% legiert ist.

2. Gegenstand nach Anspruch 1, dadurch gekennzeichnet, dass die Oxidationsschutzschicht mit einem oder mehreren Metallen aus der Gruppe Molybdän, Niob, Tantal und Hafnium in einem Gesamtanteil von 15 - 25 At% legiert ist.

3. Gegenstand nach Anspruch 1, dadurch gekennzeichnet, dass der Grundkörper aus Tantal oder Niob bzw. deren Legierungen oder Verbundwerkstoffen besteht und daß die Oxidationsschutzschicht mit 15 - 25 At% Molybdän legiert ist.

4. Gegenstand nach einem der Ansprüche 1 - 3, dadurch gekennzeichnet, dass die Reaktionssperrschicht eine Oxidschicht ist.

5. Gegenstand nach Anspruch 4, dadurch gekennzeichnet, dass die Oxidschicht eine Zirkonoxid- oder eine Hafniumoxidschicht ist.

6. Gegenstand nach einem der Ansprüche 1 - 5, dadurch gekennzeichnet, dass die Reaktionssperrschicht eine Schichtstärke zwischen 40 und 60 µm aufweist.

7. Gegenstand nach Anspruch 6, dadurch gekennzeichnet, dass die Reaktionssperrschicht durch atmosphärisches Plasmaspritzen aufgebracht ist.

## Claims

1. Article made of a parent substance consisting of a high-melting metal selected from among chromium, molybdenum, tungsten, tantalum, niobium and their alloys or composites and of an oxidation-protective coating consisting of silicides containing at least 60 at.% Si and 5-40 at.% of one or more elements selected from among Cr, Fe, Ti, Zr, Hf, B and C, or aluminides containing at least 60 at.% Al and 5-40 at.% of one or more elements selected from among Si, Cr, Ti, Zr, Hf, Pt, B and C,
characterised in that
a reaction-barrier layer is disposed between parent substance and oxidation-protective coating and that the oxidation-protective coating is alloyed with one or more metals selected from among molybdenum, niobium, tantalum and hafnium in a total content of from 2 to 35 at.%.

2. Article according to claim 1, characterised in that the oxidation-protective coating is alloyed with one or more metals selected from among molybdenum, niobium, tantalum and hafnium in a total content of from 15 - 25 at.%.

3. Article according to claim 1, characterised in that the parent substance consists of tantalum or niobium or their alloys or composites and that the oxidation-protective coating is alloyed with 15 - 25 at.% molybdenum.

4. Article according to one of claims 1 to 3,
characterised in that the reaction-barrier layer is an oxide layer.

5. Article according to claim 4, characterised in that the oxide layer is a zirconium oxide layer or a hafnium oxide layer.

6. Article according to one of claims 1 to 5,
characterised in that the reaction-barrier layer has a layer thickness of between 40 and 60 µm.

7. Article according to claim 6, characterised in that the reaction-barrier layer is applied by atmospheric plasma spraying.

## Revendications

1. Objet constitué d'un corps de base en métal à haut point de fusion du groupe formé par le chrome, le molybdène, le tungstène, le tantale, le niobium et des alliages ou produits composites de ceux-ci et d'une couche protectrice contre l'oxydation en siliciures à teneur atomique minimale de 60% de Si et à teneur atomique de 5 à 40% d'un ou plusieurs des éléments du groupe constitué par Cr, Fe, Ti, Zr, Hf, B et C, ou en aluminures à teneur atomique minimale de 60% d'AI et à teneur atomique de 5 à 40% d'un ou plusieurs des éléments du groupe constitué par Si, Cr, Ti, Zr, Hf, Pt, B et C,
caractérisé en ce que
une couche de blocage de réaction est agencée entre le corps de base et la couche protectrice contre l'oxydation et en ce que la couche protectrice contre l'oxydation est alliée à un ou plusieurs métaux du groupe formé par le molybdène, le niobium, le tantale et l'hafnium à une teneur atomique totale de 2 à 35%.

2. Objet selon la revendication 1, caractérisé en ce que la couche protectrice contre l'oxydation est alliée à un ou plusieurs métaux du groupe formé par le molybdène, le niobium, le tantale et l'hafnium selon une teneur atomique totale de 15 à 25%.

3. Objet selon la revendication 1, caractérisé en ce que le corps de base se compose de tantale ou de niobium ou d'alliages ou produits composites de ces derniers et en ce que la couche protectrice contre l'oxydation est alliée à du molybdène à une teneur atomique de 15 à 25%.

4. Objet selon l'une quelconque des revendications 1 à 3, caractérisée en ce que la couche de blocage de réaction est une couche d'oxydes.

5. Objet selon la revendication 4, caractérisé en ce que la couche d'oxydes est une couche d'oxyde de zirconium ou une couche d'oxyde d'hafnium.

6. Objet selon l'une quelconque des revendications 1 à 5, caractérisé en ce que l'épaisseur de couche de la couche de blocage de réaction est comprise entre 40 et 60 µm.

7. Objet selon la revendication 6, caractérisé en ce que la couche de blocage de réaction est appliquée par projection de plasma en atmosphère normale.
